Europäisches Patentamt

European Patent Office

Office européen des brevets

(19)

(11) Veröffentlichungsnummer : **0 162 214**
**B1**

(12) **EUROPÄISCHE PATENTSCHRIFT**

(45) Veröffentlichungstag der Patentschrift :
23.12.87

(21) Anmeldenummer : 85102873.8

(22) Anmeldetag : 13.03.85

(51) Int. Cl.⁴ : **H 01 L 43/06**, H 01 L 43/04

(54) **Verfahren und Schaltung zur Temperaturkompensation eines stromgespeisten Hallelementes.**

(30) Priorität : **18.04.84 CH 1939/84**

(43) Veröffentlichungstag der Anmeldung :
**27.11.85 Patentblatt 85/48**

(45) Bekanntmachung des Hinweises auf die Patenterteilung : **23.12.87 Patentblatt 87/52**

(84) Benannte Vertragsstaaten :
**DE FR GB SE**

(56) Entgegenhaltungen :
**DE-A- 3 303 945**
**FR-A- 1 572 426**
**US-A- 3 448 353**

(73) Patentinhaber : **LGZ LANDIS & GYR ZUG AG**
**CH-6301 Zug (CH)**

(72) Erfinder : **Popovic, Radivoje**
**Fridbach 1**
**CH-6300 Zug (CH)**
Erfinder : **Berchier, Jean-Luc**
**Neudorfstrasse 32**
**CH-6313 Menzingen (CH)**

(74) Vertreter : **Müller, Hans-Jürgen, Dipl.-Ing. et al**
**Müller, Schupfner & Gauger Lucile-Grahn-Strasse 38**
**Postfach 80 13 69**
**D-8000 München 80 (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

## Beschreibung

### Anwendungsgebiet und Zweck

Die Erfindung bezieht sich auf ein Verfahren und auf eine Schaltung zur Temperaturkompensation eines stromgespeisten Hallelementes gemäss dem Oberbegriff des Anspruchs 1 bzw. des Anspruchs 3.

### Stand der Technik

Aus der DE-A-26 40 082 ist eine Regelschaltung zu einem Hallelement bekannt, die es gestattet, eine Temperaturkompensation des Hallelementes über einen relativ schmalen Temperaturbereich zu bewerkstelligen.

### Aufgabe und Lösung

Der Erfindung liegt die Aufgabe zugrunde, ein Verfahren und eine Schaltung zur Temperaturkompensation eines Hallelementes aufwandsökonomisch zu realisieren, die es ermöglichen, bei gleichzeitiger Linearisierung des Speisestromes über einen Strombereich in der Grössenordnung von z. B. 0,1 bis 10 mA, die Temperaturabhängigkeit der Empfindlichkeit des Hallelementes über einen relativ grossen Temperaturbereich, z. B. in der Grössenordnung vom $-50\,°C$ bis $+80\,°C$, stark zu verringern, so dass ein Wert in der Grössenordnung von annähernd $\pm\,0,01\,\%/°C$ erreicht wird.

Die genannte Aufgabe wird erfindungsgemäss durch die im Kennzeichen des Anspruchs 1 bzw. des Anspruchs 3 angegebenen Merkmale gelöst.

Ausführungsbeispiele der Erfindung sind in der Zeichnung dargestellt und werden im folgenden näher beschrieben.

Es zeigen:

Fig. 1  ein Schaltbild einer Schaltung zur Temperaturkompensation eines Hallelementes,

Fig. 2  einen Querschnitt einer ersten Variante eines Hallelementes mit Steuerelektrode,

Fig. 3  einen Querschnitt einer zweiten Variante eines Hallelementes mit Steuerelektrode,

Fig. 4  einen Querschnitt einer dritten Variante eines Hallelementes mit Steuerelektrode,

Fig. 5  ein Schaltbild einer ersten Variante einer Regelschaltung,

Fig. 6  ein Schaltbild einer zweiten Variante einer Regelschaltung,

Fig. 7  ein Schaltbild einer dritten Variante einer Regelschaltung,

Fig. 8  ein Schaltbild einer vierten Variante einer Regelschaltung,

Fig. 9  ein Schaltbild einer ersten Variante eines Kompensations-Schaltkreises,

Fig. 10  ein Schaltbild einer zweiten Variante eines Kompensations-Schaltkreises und

Fig. 11  verschiedene Kennlinien des Hallelementes in Funktion der Temperatur.

Gleiche Bezugszahlen bezeichnen in allen Figuren der Zeichnung gleiche Teile.

### Beschreibung

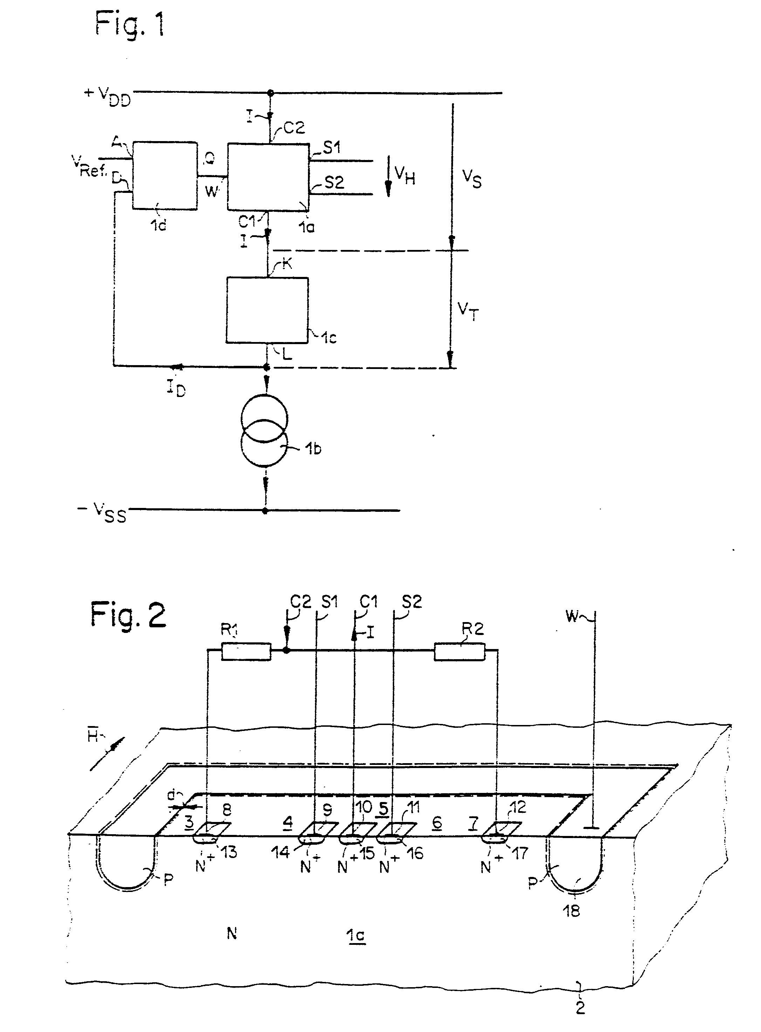

Die in der Fig. 1 dargestellte Schaltung besteht aus einem Hallelement 1a, einer Stromquelle 1b, einem Kompensations-Schaltkreis 1c und einer Regelschaltung 1d. Der positive Pol $+\,V_{DD}$ einer Speisespannung $+\,V_{DD}$; $-\,V_{SS}$ ist mit einem Pol C2 des Stromanschlusses C1; C2 des Hallelementes 1a verbunden, während dessen anderer Pol C1 über den Kompensations-Schaltkreis 1c auf einen ersten Pol der Stromquelle 1b geführt ist, dessen zweiter Pol am negativen Pol $-\,V_{SS}$ der Speisespannung $+\,V_{DD}$; $-\,V_{SS}$ liegt. Der erste Pol der Stromquelle 1b ist ausserdem noch auf einen Istwert-Eingang D der Regelschaltung 1d geführt, deren Ausgang Q mit einem Steueranschluss W des Hallelementes 1a verbunden ist, während ihr Sollwert-Eingang A an einer Referenzspannung $V_{Ref}$ liegt. Die Hallspannung $V_H$ des Hallelementes 1a erscheint an zwei Sensoranschlüssen S1 und S2 des Hallelementes 1a. Der Speisestrom I des Hallelementes 1a erzeugt in diesem Hallelement 1a einen Spannungsabfall $V_{C2,C1} = V_S$ und im Kompensations-Schaltkreis 1c einen Spannungsabfall $V_T$. Der Eingangsstrom $I_D$ am Istwert-Eingang D der Regelschaltung 1d ist bedeutend kleiner als der Speisestrom I des Hallelementes 1a.

Das Hallelement 1a ist z. B. eines der Hallelemente, die in dem schweizerischen Patentgesuch Nr. 6739/83-1 beschrieben sind; Vgl. auch die entsprechende EP-A-0 148 330. In der Fig. 2 ist eines dieser Hallelemente als Beispiel dargestellt. Das in der Fig. 2 dargestellte Hallelement 1a besteht aus einem Substrat 2 eines bestimmten Material-Leitfähigkeitstyps, z. B. des Typs N. An der Oberfläche des Substrates 2 und in der Darstellung der Fig. 2 von links beginnend sind auf einer z. B. annähernd geraden Linie, nebeneinander und in der angegebenen Reihenfolge eine erste Stromteilelektrode 3, eine erste Sensorelektrode 4, eine erste Stromelektrode 5, eine zweite Sensorelektrode 6 und eine zweite Stromteilelektrode 7 angeordnet. Die beiden Stromteilelektroden 3 und 7 sind über je einen Widerstand R1 bzw. R2 mit dem Pol C2 des Stromanschlusses C1; C2 des Hallelementes 1a verbunden, während dessen anderer Pol C1 auf die erste Stromelektrode 5 geführt ist. Die beiden Stromteilelektroden 3 und 7 bilden somit zusammen die zweite Stromelektrode des Hallelementes 1a. Wenn das Hallelement 1a ein integriertes Hallelement ist, ist es vorteilhaft, die Widerstände R1 und R2 nicht wie in der Fig. 2 dargestellt ausserhalb des Substrates 2 zu montieren, sondern sie in das Substrat 2 wie bei den Elementen einer integrierten Schaltung einzudiffundieren. Die beiden Sensorelektroden 4 und 6 einerseit und die beiden Stromteilelektroden 3 und 7 anderseits sind z. B. annähernd symmetrisch zu der zentralgelegenen ersten Stromelektrode 5 angeordnet. Die beiden Sensorelektroden 4 und 6 besitzen je einen Sensoranschluss S1 bzw. S2. Jede Elektrode 3 bis 7 besteht aus je einem Anschlusskontakt 8, 9, 10, 11 bzw. 12 und aus je einer Kontaktdiffusionsschicht 13, 14, 15, 16 bzw. 17. Alle Kontaktdiffusionsschichten 13 bis 17 sind ringförmig von einer Steuerelektrode 18 umgeben, die einen Steueranschluss W besitzt. Die Steuerelektrode 18 und die Kontaktdiffusionsschichten 13 bis 17 aller anderen Elektroden 3 bis 7 des Hallelementes 1a sind an der Oberfläche in dem Substrat 2 eindiffundiert. Die Steuerelektrode 18 ist vom entgegengesetzten Material-Leitfähigkeitstyp, d. h. vom Typ P, wie das Substrat 2 und die Kontaktdiffusionsschichten 13 bis 17, die alle vom gleichen Material-Leitfähigkeitstyp sind, nämlich vom Typ N. Die Steuerelektrode 18 besitzt eine grössere Diffusionstiefe als die Kontaktdiffusionsschichten 13 bis 17, die alle annähernd eine gleiche Diffusionstiefe haben und die ausserdem alle stark mit Fremdatomen dotiert sind, so dass sie vom Material-Leitfähigkeitstyp N+ sind. Die Steuerelektrode 18 ist dermassen an einer elektrischen Spannung zu legen, dass der P/N-Uebergang zwischen der Steuerelektrode 18 und dem Substrat 2 in Sperrichtung gepolt ist. Die dadurch entstehende Verarmungszone (« Depletion layer ») besitzt eine Breite d und ist in der Fig. 2 gestrichelt dargestellt. Ein mit dem Hallelement 1a zu messendes Magnetfeld $\vec{H}$ ist parallel zu der Oberfläche des Substrates 2 angeordnet und zwar vorteilhaft senkrecht zu der Geraden, die die Kontaktdiffusionsschichten 13 bis 17 miteinander verbindet. Die Arbeitsweise dieses Hallelementes 1a ist in dem schweizerischen Patentgesuch Nr. 6739/83-1 beschrieben.

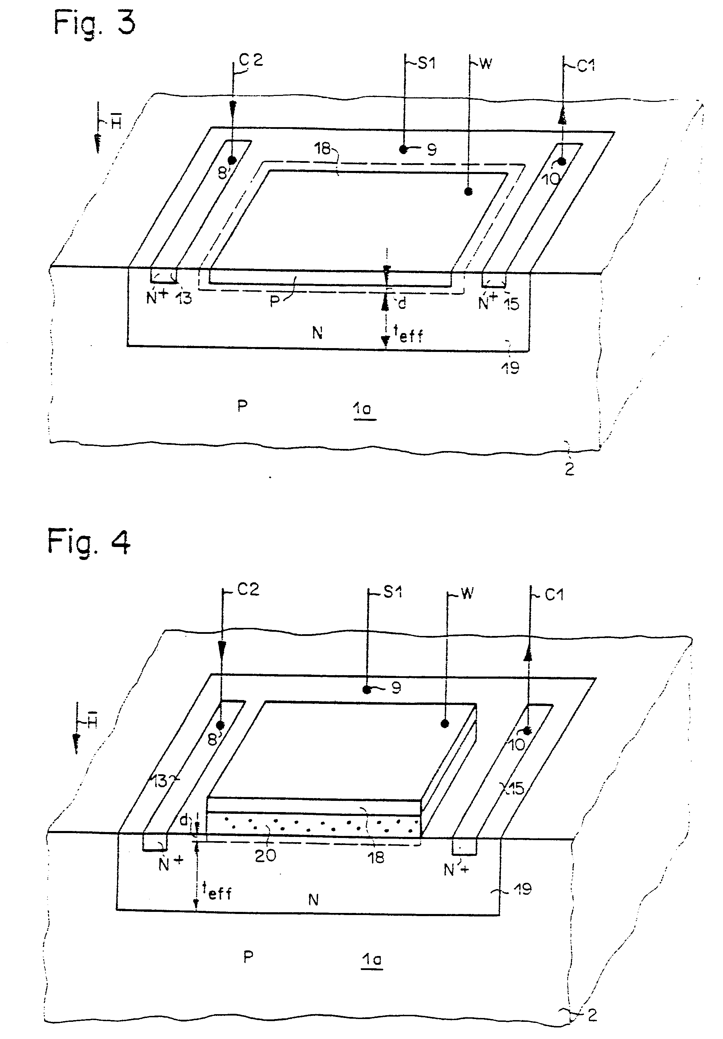

Das Hallelement 1a kann in einer zweiten Variante das in der Fig. 3 dargestellte Hallelement sein. Dieses besteht ebenfalls aus einem Substrat 2 eines bestimmten Material-Leitfähigkeitstyps, z. B. des Typs P, in dem an der Oberfläche eine Wanne 19 vom entgegengesetzten Material-Leitfähigkeitstyp, also vom Typ N, eindiffundiert ist. An der Oberfläche sind in der Wanne 19 die Steuerelektrode 18 und vier Kontaktdiffusionsschichten 13 bis 16 der Elektroden des Halle- mentes 1a eindiffundiert. Zwischen den zwei parallelen und annähernd gleich langen Kontaktdiffusionsschichten 13 und 15 ist die annähernd gleich lange Steuerelektrode 18 parallel angeordnet. Die beiden Kontaktdiffusionsschichten 13 und 15 sowie die Steuerelektrode 18 sind z. B. rechteckförmig. Die beiden restlichen Kontaktdiffusionsschichten 14 und 16 sind ausserhalb der Fläche der Steuerelektrode 18 z. B. auf derjenigen Symmetrieachse der beiden Kontaktdiffusionsschichten 13 und 15 sowie der Steuerelektrode 18 angeordnet, die parallel zu der Länge der Kontaktdiffusionsschichten 13 und 15 verläuft. Von den beiden Kontaktdiffusionsschichten 14 und 16 ist in der Fig. 3 nur der Anschlusskontakt 9 der Kontaktdiffusionsschicht 14 sichtbar. Jede der vier Kontaktdiffusionsschichten 13 bis 16 ist stark mit Fremdatomen dotiert und vom gleichen Material-Leitfähigkeitstyp wie die Wanne 19, d. h. vom Typ N⁻. Sie besitzen je einen Anschlusskontakt 8,

9, 10 bzw. 11 mit je einem Anschluss C2, S1, C1 bzw. S2. Die Kontaktdiffusionsschicht 15 mit ihrem Anschlusskontakt 10 bildet eine erste Stromelektrode, die Kontaktdiffusionsschicht 13 mit ihrem Anschlusskontakt 8 eine zweite Stromelektrode, die Kontaktdiffusionsschicht 14 mit ihrem Anschlusskontakt 9 eine erste Sensorelektrode und die Kontaktdiffusionsschicht 16 mit ihrem Anschlusskontakt 11 eine zweite Sensorelektrode. Die zweite Sensorelektrode liegt mit ihrem Anschluss S2 vor der Schnittebene der Fig. 3 und ist aus diesem Grunde in der Fig. 3 nicht sichtbar. Die Steuerelektrode 18 besitzt einen Steueranschluss W und ist vom entgegengesetzten Material-Leitfähigkeitstyp wie die Wanne 19, d. h. sie ist vom Typ P. Die Diffusionstiefen aller Kontaktdiffusionsschichten 13 bis 16 sowie diejenige der Steuerelektrode 18 sind z. B. annähernd gleich gross. Die Steuerelektrode 18 ist dermassen an einer elektrischen Spannung zu legen, dass der P/N-Uebergang zwischen der Steuerelektrode 18 und der Wanne 19 in Sperrrichtung gepolt ist. Die dadurch entstehende Verarmungszone hat eine Breite d. Sie ist in der Fig. 3 ebenfalls gestrichelt dargestellt. Ein mit dem Hallelement 1a zu mes- sendes Magnetfeld $\vec{H}$ muss diesmal senkrecht zur Oberfläche des Substrates 2 wirksam sein.

Das Hallelement 1a kann in einer dritten Variante das in der Fig. 4 dargestellte Hallelement sein. Es ist ähnlich aufgebaut wie das in der Fig. 3 dargestellte Hallelement 1a, nur dass die Steuerelektrode 18 diesmal nicht in die Wanne 19 eindiffundiert ist, sondern an der gleichen Stelle wie in der Fig. 3 auf der Oberfläche der Wanne 19 und von dieser durch eine dünne Isolationsschicht 20 getrennt als elektrisch gut leitende Schicht aus Metall oder Polysilizium aufgetragen ist. Die Isolationsschicht 20 besteht z. B. aus SiO₂. Die Steuerelektrode 18 arbeitet hier als « Gate » und eine an ihr anstehende Spannung erzeugt je nach Polarität und Wert der anliegenden Spannung in der darunter liegenden Oberflächenschicht der Wanne 19 eine Verarmungs- oder eine Anreichungszone (« Depletion »- oder « Enhancement-layer ») der Dicke d. Diese Zone ist auch in der Fig. 4 gestrichelt dargestellt.

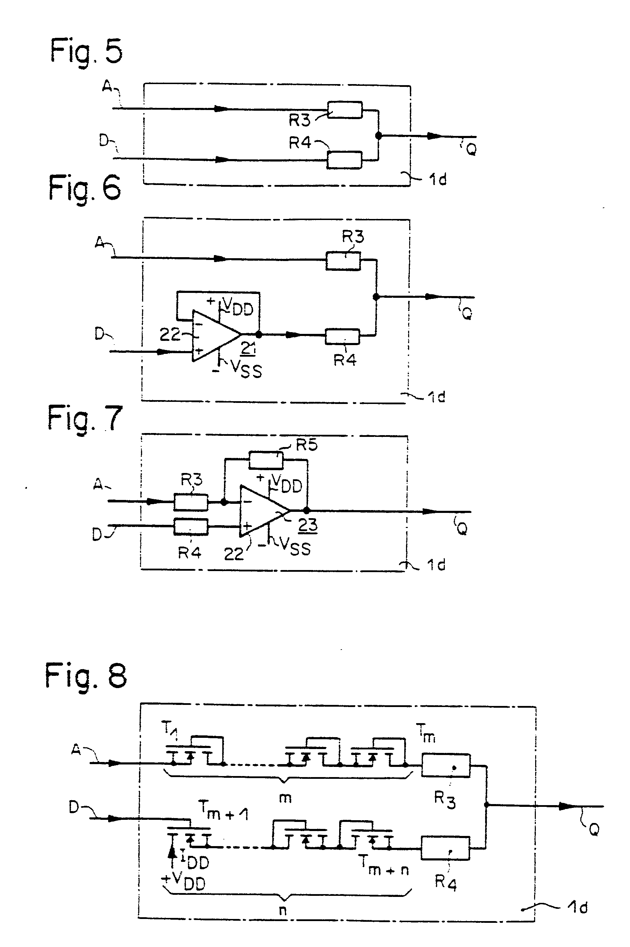

Die in der Fig. 5 dargestellte Regelschaltung 1d besteht aus zwei in Reihe geschalteten Widerständen R3 und R4, deren gemeinsamer Pol den Ausgang Q der Regelschaltung 1d bildet und deren anderer Pol jeweils einen· Sollwert- bzw. einen Istwert-Eingang A bzw. D der Regelschaltung 1d darstellt. Der Verstärkungsfaktor dieser Regelschaltung 1d ist kleiner als Eins.

Die in der Fig. 6 dargestellte Regelschaltung 1d entspricht annähernd der in der Fig. 5 dargestellten Schaltung, nur dass zusätzlich zwischen dem Istwert-Eingang D der Regelschaltung 1d und dem zugehörigen Widerstand R4 ein Spannungsfolger 21 geschaltet ist. Der Spannungsfolger 21 besteht vorteilhaft aus der an sich bekannten Schaltung eines Operationsverstärkers 22, dessen Ausgang mittels einer Kurzschlussverbindung mit dem invertierenden Eingang des Operationsverstärkers 22 verbunden ist und dessen nichtinvertierender Eingang· den Eingang des Spannungsfolgers 21 bildet. Der Eingangsstrom dieser Regelschaltung 1d ist wegen des hochohmigen Eingangs des Spannungsfolgers 21 sehr niedrig. Ihr Verstärkungsfaktor ist allerdings ebenfalls kleiner als Eins.

Die in der Fig. 7 dargestellte Regelschaltung 1d besteht aus einem Differenzverstärker 23, dessen Ausgang den Ausgang Q der Regelschaltung 1d bildet und dessen beide Eingänge je einen Sollwert- bzw. Istwert-Eingang A bzw. D der Regelschaltung 1d darstellen. Der Differenzverstärker 23 ist z. B. die an sich bekannte, mittels eines Operationsverstärkers 22 aufgebaute Schaltung eines rückgekoppelten Verstärkers. Der Ausgang des Operationsverstärkers 22 ist dabei mit Hilfe eines Widerstandes R5 auf den invertierenden Eingang des Operationsverstärkers 22 rückgekoppelt, der seinerseits noch über den Widerstand R3 auf den Sollwert-Eingang A der Regelschaltung 1d geführt ist. Der nichtinvertierende Eingang des Operationsverstärkers 22 ist über den Widerstand R4 mit dem Istwert-Eingang D der Regelschaltung 1d verbunden. Der Verstärkungsfaktor dieser Regelschaltung kann grösser als Eins sein.

In den beiden Figuren 6 und 7 ist der Operationsverstärker 22 jeweils von der Speisespannung $+ V_{DD}$; $- V_{SS}$ gespeist.

Die in der Fig. 8 dargestellte Regelschaltung 1d entspricht annähernd der in der Fig. 5 dargestellten Schaltung, nur dass zusätzlich zwischen dem Sollwert-Eingang A und seinem zugehörigen Widerstand R3 eine Reihenschaltung der « Source-Drain »-Strecken von m MOS-Transistoren $T_1$ bis $T_m$ und zwischen dem Istwert-Eingang D und seinem zugehörigen Widerstand R4 eine Reihenschaltung der « Source-Drain »-Strecken von n MOS-Transistoren $T_{m+1}$ bis $T_{m+n}$ geschaltet ist, wobei im letzten Fall der Istwert-Eingang D mit dem « Gate » des ersten der n MOS-Transistoren $T_{m+1}$ und die « Source » des ersten der n MOS-Transistoren $T_{m+1}$ mit einem, nämlich dem positiven Pol $+ V_{DD}$ der Speisespannung $+ V_{DD}$; $- V_{SS}$ verbunden sind. Alle andere « Gates » der MOS-Transistoren sind jeweils mit dem « Drain » und das Substrat aller MOS-Transistoren $T_1$ bis $T_{m+n}$ jeweils mit der « Source » des zugehörigen Transistors verbunden. Alle MOS-Transistoren sind z. B. gleich und in der Fig. 8 wurde das Vorhandensein von N-Kanal MOS-Transistoren des Anreicherungstyps angenommen. Wenn die ganzzahligen Werte m und n so gewählt werden, dass die Gleichung m·R4 = n·R3 erfüllt ist, dann ist diese Regelschaltung 1d annähernd unabhängig von der Temperatur T. Da der « Gate »-Eingang eines MOS-Transistors sehr hochohmig ist, ist der Istwert-Eingang D ebenfalls hochohmig und sein Eingangsstrom $I_D$ sehr klein und praktisch annähernd gleich Null. Der von der Speisespannung $+ V_{DD}$; $- V_{SS}$ zu liefernde Speisestrom $I_{DD}$ ist ebenfalls sehr klein, selbst wenn die beiden Widerstände R3 und R4 niederohmig sind.

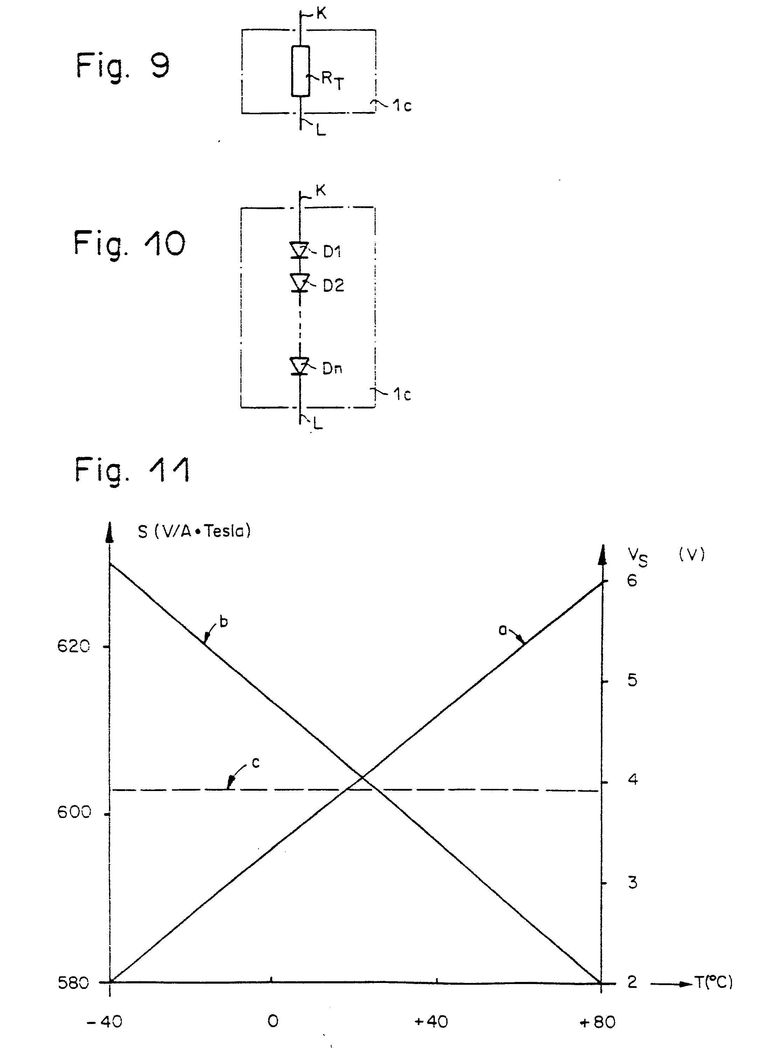

Der in den Figuren 9 und 10 dargestellte Kompensations-Schaltkreis 1c besteht aus einem temperaturempfindlichen Element. In der Fig. 9 ist das temperaturempfindliche Element ein temperaturabhängiger Widerstand $R_T$. In der Fig. 10 ist das temperaturempfindliche Element eine Reihenschaltung von n in Durchlassrichtung gepolten Dioden D1, D2, ..., Dn. Die beiden Pole des temperaturabhängigen Widerstandes $R_T$ bzw. die beiden Pole der Reihenschaltung stellen dabei jeweils die beiden Anschlüsse K und L des Kompensations-Schaltkreises 1c dar. Bei Verwendung des Kompensations-Schaltkreises 1c besteht die Regelschaltung 1d im Extremfall z. B. nur aus einer Drahtverbindung, die den Istwert-Eingang D der Regelschaltung 1d mit deren Ausgang Q verbindet.

Die Figur 11 enthält drei Kennlinien a, b und c. Die Kennlinie a stellt den durch den Speisestrom I im Hallelement 1a erzeugten Spannungsabfall $V_S$, die Kennlinie b die Empfindlichkeit S des Hallelementes 1a ohne Temperaturkompensation und die Kennlinie c die Empfindlichkeit S des Hallelementes 1a mit Temperaturkompensation jeweils in Funktion der Temperatur T dar. Alle dargestellten Kennlinien a, b und c sind annähernd gerade·Linien, wobei mit jeweils steigenden Temperaturen·T die Kennlinie a steigende Werte, die Kennlinie b sinkende Werte und die Kennlinie c konstante Werte besitzt.

Funktionsbeschreibung

Das in der Fig. 1 dargestellte Hallelement 1a ist durch die Stromquelle 1b stromgespeist. Für ein stromgespeistes Hallelement 1a gelten die folgenden Gleichungen :

$$V_H = (R_H/t_{eff}) \cdot I \cdot B \qquad (1),$$
$$S = R_H/t_{eff} \qquad (2) \text{ und}$$
$$V_S = \rho \cdot I \qquad (3),$$

wobei die einzelnen Parameter die folgende Bedeutung haben :

$V_H$ : Hallspannung,

$R_H$ : Hallkoeffizient,

$t_{eff}$ : wirksame Dicke des Hallelementes 1a,

I : Speisestrom innerhalb des Hallelementes 1a,

B : Induktion µH eines zu messenden Magnetfeldes H,

S : Empfindlichkeit des Hallelementes 1a pro Stromeinheit,

$V_S$ : im Hallelement 1a durch den Speisestrom I erzeugter Spannungsabfall und

$\rho$ : elektrischer Widerstand des Hallelementes 1a.

Unter dem Einfluss der Temperatur T ändert sich hauptsächlich der Wert des elektrischen Widerstandes $\rho$ und der Wert der wirksamen Dicke $t_{eff}$. Der Wert des elektrischen Widerstandes $\rho$ und der Wert der wirksamen Dicke $t_{eff}$ steigen dabei mit steigender Temperatur T. Soll die Empfindlichkeit S des Hallelementes 1a, die gemäss der Kennlinie b der Fig. 11 einen mit steigender Temperatur sinkenden Verlauf besitzt, temperaturkompensiert, d. h. bei variabler Temperatur T konstant gehalten werden, so ist die wirksame Dicke $t_{eff}$ des Hallelementes 1a annähernd konstant zuhalten. Dies geschieht mit Hilfe der Steuerelektrode 18 (siehe die Figuren 2 bis 4) des Hallelementes 1a und mit Hilfe einer Regelung, deren Sollwert die konstante Referenzspannung $V_{Ref}$ und deren Istwert mindestens den im Hallelement 1a durch den Speisestrom I erzeugten Spannungsabfall $V_S$ enthält. Dieser Istwert enthält nämlich ausschliesslich den Spannungsabfall $V_S$, wenn der Kompensations-Schaltkreis 1c nur aus einer Drahtverbindung zwischen den Anschlüssen K und L besteht. Wenn der Kompensations-Schaltkreis 1c aus einem temperaturempfindlichen Element besteht, dann enthält die am Istwert-Eingang D der Regelschaltung 1d anstehende Spannung, d. h. der Istwert, noch zusätzlich einen im temperaturempfindlichen Element durch den Speisestrom I erzeugten Spannungsabfall $V_T$.

Die Regelung erfolgt somit mit der Regelschaltung 1d, die eine konstante Sollwert-Eingangsspannung $V_{Ref}$ und eine Spannung am Istwert-Eingang D besitzt, die mindestens den im Hallelement 1a durch den Speisestrom I erzeugten Spannungsabfall $V_S$ enthält. Der Ausgang Q der Regelschaltung 1d, der über den Steueranschluss W mit der Steuerelektrode 18 des Hallelementes 1a verbunden ist, wirkt über diese Steuerelektrode 18 dermassen auf die wirksame Dicke $t_{eff}$ des Hallelementes 1a ein, dass diese annähernd konstant bleibt und somit die Empfindlichkeit S des Hallelementes 1a annähernd unabhängig von der Temperatur T wird. Mit steigender Temperatur T steigt der Wert des elektrischen Widerstandes $\rho$ und gemäss Gleichung (3) auch der Wert des Spannungsabfalls $V_S$ (siehe Kennlinie a der Fig. 11). Der mit der Temperatur T steigende Wert des Spannungsabfalls $V_S$ wird in der Regelschaltung 1d mit dem Sollwert $V_{Ref}$ verglichen und erzeugt anschliessend mit Hilfe der Steuerelektrode 18 eine Verkleinerung der wirksamen Dicke $t_{eff}$ des Hallelementes 1a. Er wirkt somit der durch die steigende Temperatur T verursachten Vergrösserung der wirksamen Dicke $t_{eff}$ des Hallelementes 1a entgegen, so dass diese und damit auch die Empfindlichkeit S des Hallelementes 1a trotz steigender Temperatur T konstant bleibt (siehe Fig. 11, Kennlinie c). Sinkt die Temperatur T dagegen, so geschieht das Gleiche in umgekehrter Richtung.

Ueber einen relativ grossen Temperaturbereich, z. B. in der Grössenordnung von — 50 °C bis + 80 °C, ist so ein Temperaturkoeffizient der Empfindlichkeit S des Hallelementes 1a von annähernd ± 0,01 %/°C erreichbar.

Die wirksame Dicke $t_{eff}$ des Hallelementes 1a ist auch vom Speisestrom I abhängig. Da der im Istwert zumindest enthaltene Spannungsabfall $V_S$ nicht nur über $\rho$ eine Funktion der Temperatur, sondern gemäss der Gleichung (3) auch eine Funktion des Speisestromes I ist, regelt die Regelschaltung 1d auch den Einfluss einer eventuellen Variation des Speisestromes I aus, so dass die Abhängigkeit der wirksamen Dicke $t_{eff}$ und damit auch die Abhängigkeit der Empfindlichkeit S des Hallelementes 1a vom Speisestrom I kompensiert oder zumindest stark reduziert wird. Dies führt zu einer Linearisierung der Kennlinie der Empfindlichkeit S des Hallelementes 1a in Funktion des Speisestromes I über einen relativ grossen Strombereich, z. B. in der Grössenordnung von 0,1 bis 10 mA.

## Patentansprüche

1. Verfahren zur Temperaturkompensation eines stromgespeisten Hallelementes (1a) mit Hilfe einer Regelung, deren Istwert mindestens einen im Hallelement (1a) durch einen Speisestrom (I) erzeugten Spannungsabfall $(V_S)$ enthält, dadurch gekennzeichnet, dass die Regelung mit Hilfe einer Steuerelektrode (18) des Hallelementes (1a) erfolgt, die auf die wirksame Dicke $(t_{eff})$ des Hallelementes (1a) dermassen wirkt, dass die Empfindlichkeit (S) des Hallelementes (1a) annähernd unäbhängig von der Temperatur (T) wird.

2. Verfahren nach Anspruch 1, dadurch gekennzeichnet, dass der Istwert noch zusätzlich einen in einem temperaturempfindlichen Element (1c) durch den Speisestrom (I) erzeugten Spannungsabfall $(V_T)$ enthält.

3. Schaltung zur Temperaturkompensation eines stromgespeisten Hallelementes (1a) mit einer Regelschaltung (1d), deren Spannung am Istwert-Eingang (D) mindestens einen im Hallelement (1a) durch einen Speisestrom (I) erzeugten Spannungsabfall $(V_S)$ enthält, dadurch gekennzeichnet, dass der Ausgang (Q) der Regelschaltung (1d) mit einer Steuerelektrode (18) des Hallelementes (1a) verbunden ist und über diese Steuerelektrode (18) des Hallelementes (1a) auf die wirksame Dicke $(t_{eff})$ des Hallelementes (1a) dermassen wirksam ist, dass die Empfindlichkeit (S) des Hallelementes (1a) annähernd unabhängig von der Temperatur (T) ist.

4. Schaltung nach Anspruch 3, dadurch gekennzeichnet, dass die Steuerelektrode (18) und alle Kontaktdiffusionsschichten (13 bis 17) der anderen Elektroden (3 bis 7) des Hallelementes (1a) an der Oberfläche in einem Substrat (2) eindiffundiert sind, dass die Kontaktdiffusionsschichten (13 bis 17) von der Steuerelektrode (18) ringförmig umgeben sind, dass die Steuerelektrode (18) vom entgegengesetzten Leitfähigkeitstyp ist wie das Substrat (2) und die Kontaktdiffusionsschichten (13 bis 17), dass die Steuerelektrode (18) eine grössere Diffusionstiefe besitzt als die Kontaktdiffusionsschichten (13 bis 17) und dass der P/N-Uebergang zwischen der Steuerelektrode (18) und dem Substrat (2) in Sperrichtung gepolt ist.

5. Schaltung nach Anspruch 3, dadurch gekennzeichnet, dass die Steuerelektrode (18) und vier Kontaktdiffusionsschichten (13 bis 16) der Elektroden des Hallelementes (1a) an der Oberfläche in einer Wanne (19) vom entgegengesetzten Leitungstyp eines die Wanne enthaltenden Substrats (2) eindiffundiert sind, dass zwischen zwei parallen und annähernd gleich langen Kontaktdiffusionsschichten (13, 15) eine annähernd gleich lange Steuerelektrode (18) parallel angeordnet ist, dass die Steuerelektrode (18) vom entgegengesetzten Leitfähigkeitstyp ist wie die Wanne (19) und die Kontaktdiffusionsschichten (13 bis 16) und dass der P/N-Uebergang zwischen der Steuerelektrode (18) und der Wanne (19) in Sperrichtung gepolt ist.

6. Schaltung nach Anspruch 3, dadurch gekennzeichnet, dass vier Kontakdiffusionsschichten (13 bis 16) der Elektroden des Hallelementes (1a) an der Oberfläche in einer Wanne (19) vom entgegengesetzten Leitungstyp eines die Wanne enthaltenden Substrats (2) eindiffundiert sind, dass die vier Kontaktdiffusionsschichten (13 bis 16) vom gleichen Leitfähigkeitstyp wie die Wanne sind und dass zwischen zwei parallelen und annähernd gleich langen Kontaktdiffusionsschichten (13, 15) eine annähernd gleich lange Steuerelektrode (18) parallel zu den beiden Kontaktdiffusionsschichten (13, 15) auf der Oberfläche der Wanne (19) und von dieser durch eine dünne Isolationsschicht (20) getrennt als elektrisch gut leitende Schicht aufgetragen ist.

7. Schaltung nach einem der Ansprüche 3 bis 6, dadurch gekennzeichnet, dass die Regelschaltung (1d) aus zwei in Reihe geschalteten Widerständen (R3, R4) besteht, deren gemeinsamer Pol den Ausgang (Q) der Regelschaltung (1d) bildet und deren anderer Pol jeweils einen Sollwert- bzw. einen Istwert-Eingang (A, D) der Regelschaltung (1d) darstellt.

8. Schaltung nach Anspruch 7, dadurch gekennzeichnet, dass zwischen dem Istwert-Eingang (D) der Regelschaltung (1d) und dem zugehörigen Widerstand (R4) ein Spannungsfolger (21) geschaltet ist.

9. Schaltung nach Anspruch 7, dadurch gekennzeichnet, dass zwischen dem Sollwert-Eingang (A) und seinem zugehörigen Widerstand R3 eine Reihenschaltung der « Source-Drain »-Strecken von m MOS-Transistoren ($T_1$ bis $T_m$) und zwischen dem Istwert-Eingang (D) und seinem zugehörigen Widerstand R4 eine Reihenschaltung der « Source-Drain »-Strecken von n MOS-Transistoren ($T_{m+1}$ bis $T_{m+n}$) geschaltet ist, wobei im letzten Fall der Istwert-Eingang (D) mit dem « Gate » des ersten der n MOS-Transistoren ($T_{m+1}$) und die « Source » des ersten der n MOS-Transistoren ($T_{m+1}$) mit einem Pol der Speisespannung ($+ V_{DD}$; $— V_{SS}$) verbunden sind.

10. Schaltung nach Anspruch 9, dadurch gekennzeichnet, dass die Werte m und n so gewählt sind, dass die Gleichung $m \cdot R4 = n \cdot R3$ erfüllt ist.

11. Schaltung nach einem der Ansprüche 3 bis 6, dadurch gekennzeichnet, dass die Regelschaltung (1d) aus einem Differenzverstärker (23) besteht, dessen Ausgang den Ausgang (Q) der Regelschaltung (1d) bildet und dessen beide Eingänge je einen Sollwert- bzw. Istwert-Eingang (A bzw. D) der Regelschaltung (1d) darstellen.

12. Schaltung nach einem der Ansprüche 3 bis 6, dadurch gekennzeichnet, dass die Spannung am Istwert-Eingang (D) noch zusätzlich einen in einem temperaturempfindlichen Element durch den Speisestrom (I) erzeugten Spannungsabfall ($V_T$) enthält.

13. Schaltung nach Anspruch 12, dadurch gekennzeichnet, dass das temperaturempfindliche Element ein temperaturabhängiger Widerstand ($R_T$) ist.

14. Schaltung nach Anspruch 12, dadurch gekennzeichnet, dass das temperaturempfindliche Element eine Reihenschaltung von in Durchlassrichtung gepolten Dioden (D1, D2, ... Dn) ist.

15. Schaltung nach einem der Ansprüche 12 bis 14, dadurch gekennzeichnet, dass die Regelschaltung (1d) nur aus einer Drahtverbindung besteht.

**Claims**

1. A process for temperature compensation of a current-fed Hall element (1a) by means of a regulation whose actual value includes at least one voltage drop ($V_S$) which is produced in the Hall element (1a) by a feed current (I), characerised in that regulation is effected by means of a control electrode (18) of the Hall element (1a), which acts on the effective thickness ($t_{eff}$) of the Hall element (1a) in such a way that the sensitivity (S) of the Hall element (1a) is approximately independent of temperature (T).

2. A process according to claim 1 characterised in that the actual value also additionally includes a voltage drop ($V_T$) which is produced in a temperature-sensitive element (1c) by the feed current (I).

3. A circuit for temperature compensation of a current-fed Hall element (1a) with a regulating circuit (1d) whose voltage at the actual value input (D) contains at least one voltage drop ($V_S$) which is produced in the Hall element (1a) by a feed current (I), characterised in that the output (Q) of the regulating circuit (1d) is connected to a control electrode (18) of the Hall element (1a) and by way of said control electrode (18) of the Hall element (1a) is operative on the effective thickness ($t_{eff}$) of the Hall element (1a) in such a way that the sensitivity (S) of the Hall element (1a) is approximately independent of temperature (T).

4. A circuit according to claim 3 characterised in that the control electrode (18) and all contact diffusion layers (13 to 17) of the other electrodes (3 to 7) of the Hall element (1a) are diffused at the surface in a substrate (2), that the contact diffusion layers (13 to 17) are annularly surrounded by the control electrode (18), that the control electrode (18) is of opposite conductivity type from the substrate (2) and the contact diffusion layers (13 to 17), that the control electrode (18) has a greater depth of diffusion than the contact diffusion layers (13 to 17) and that the P/N junction between the control electrode (18) and the substrate (2) is poled in the reverse direction.

5. A circuit according to claim 3 characterised in that the control electrode (18) and four contact diffusion layers (13 to 16) of the electrodes of the Hall element (1a) are diffused at the surface in a well (19) of opposite conductivity type to a substrate (2) containing the well, that arranged in parallel relationship between two parallel and approximately equal-length contact diffusion layers (13, 15) is an approximately equal-length control electrode (18), that the control electrode (18) is of opposite conductivity type from the well (19) and the contact diffusion layers (13 to 16), and that the P/N junction between the control electrode (18) and the well (19) is poled in the reverse direction.

6. A circuit according to claim 3 characterised in that four contact diffusion layers (13 to 16) of the electrodes of the Hall element (1a) are diffused at the surface in a well (19) of opposite conductivity type to a substrate (2) containing the well, that the four contact diffusion layers (13 to 16) are of the same conductivity type as the well and that between two parallel and approximately equal-length contact diffusion layers (13, 15) an approximately equal-length control electrode (18) is applied parallel to the two contact diffusion layers (13, 15) on the surface of the well (19) and separated therefrom by a thin insulating layer (20), constituting a layer which has good electrical conductivity.

7. A circuit according to one of claims 3 to 6 characterised in that the regulating circuit (1d) comprises two series-connected resistors (R3, R4) whose common terminal forms the output (Q) of the regulating circuit (1d) and whose other pole respectively represents a reference value input and an actual value input (A, D) of the regulating circuit (1d).

8. A circuit according to claim 7 characterised in that a voltage follower (21) is connected between the actual value input (D) of the regulating circuit (1d) and the associated resistor (R4).

9. A circuit according to claim 7 characterised in that connected between the reference value input (A) and its associated resistor (R3) is a series circuit of the source-drain paths of m MOS-transistors ($R_1$ to $T_m$) and connected between the actual value input (D) and its associated resistor (R4) is a series circuit of the source-drain paths of n MOS-transistors ($T_{m+1}$ to $T_{m+n}$), wherein in the latter case the actual value input (D) is connected to the gate of the first of the n MOS-transistors ($T_{m+1}$) and the source of the first of the n MOS-transistors ($T_{m+1}$) is connected to a terminal of the feed voltage ($+ V_{DD}$ ; $- V_{SS}$).

10. A circuit according to claim 9 characterised in that the values m and n are so selected as to comply with the equation $m \cdot R4 = n \cdot R3$.

11. A circuit according to one of claims 3 to 6 characterised in that the regulating circuit (1d) comprises a differential amplifier (23) whose output forms the output (Q) of the regulating circuit (1d) and whose two inputs respectively represent a reference value input and an actual value input (A, D) of the regulating circuit (1d).

12. A circuit according to one of claims 3 to 6 characterised in that the voltage at the actual value input (D) also additionally includes a voltage drop ($V_T$) which is produced in a temperature-sensitive element by the feed current (I).

13. A circuit according to claim 12 characterised in that the temperature-sensitive element is a temperature-dependent resistor ($R_T$).

14. A circuit according to claim 12 characterised in that the temperature-sensitive element is a series circuit of diodes (D1, D2, ... Dn) which are poled in the forward direction.

15. A circuit according to one of claims 12 to 14 characterised in that the regulating circuit (1d) only comprises a wired connection.

## Revendications

1. Procédé de compensation thermique d'un dispositif à effet Hall (1a) alimenté en courant, à l'aide d'une régulation dont la valeur instantanée comprend au moins une chute de tension ($V_S$) produite par un courant d'alimentation (I) dans le dispositif à effet Hall (1a), ledit procédé étant caractérisé en ce que la régulation est effectuée à l'aide d'une électrode de commande (18) du dispositif à effet Hall (1a), qui agit sur l'épaisseur effective ($t_{eff}$) du dispositif (1a) de façon que la sensibilité (S) de ce dernier soit sensiblement indépendante de la température (T).

2. Procédé selon revendication 1, caractérisé en ce que la valeur instantanée comprend en outre une chute de tension ($V_T$) produite par le courant d'alimentation (I) dans un élément (1c) sensible à la température.

3. Montage de compensation thermique d'un dispositif à effet Hall (1a) alimenté en courant, avec un montage régulateur (1d) dont la tension sur l'entrée de valeur instantanée (D) comprend au moins une chute de tension ($V_S$) produite par un courant d'alimentation (I) dans le dispositif à effet Hall (1a), ledit montage étant caractérisé en ce que la sortie (Q) du montage régulateur (1d) est reliée à une électrode de commande (18) du dispositif à effet Hall (1a) et agit par l'intermédiaire de ladite électrode de commande (18) sur l'épaisseur effective ($t_{eff}$) du dispositif à effet Hall (1a) de façon que la sensibilité (S) de ce dernier soit sensiblement indépendante de la température (T).

4. Montage selon revendication 3, caractérisé en ce que l'électrode de commande (18) et toutes les couches diffusées de contact (13 à 17) des autres électrodes (3 à 7) du dispositif à effet Hall (1a) sont diffusées à la surface d'un substrat (2) ; les couches diffusées de contact (13 à 17) sont entourées par l'électrode de commande (18) en anneau ; l'électrode de commande (18) est du type de conduction opposé à celui du substrat (2) et des couches diffusées de contact (13 à 17) ; l'électrode de commande (18) présente une profondeur de diffusion supérieure à celle des couches diffusées de contact (13 à 17) ; et la jonction P/N entre l'électrode de commande (18) et le substrat (2) est polarisée dans le sens inverse.

5. Montage selon revendication 3, caractérisé en ce que l'électrode de commande (18) et quatre couches diffusées de contact (13 à 16) des électrodes du dispositif à effet Hall (1a) sont diffusées à la surface d'un caisson (19) de type de conduction opposé à celui du substrat (2) le contenant ; une électrode de commande (18) sensiblement de même longueur est disposée parallèlement entre deux couches diffusées de contact (13, 15) parallèles et sensiblement de même longueur ; l'électrode de commande (18) est du même type de conduction que le caisson (19) et les couches diffusées de contact (13 à 16) ; et la jonction P/N entre l'électrode de commande (18) et le caisson (19) est polarisée dans le sens inverse.

6. Montage selon revendication 3, caractérisé en ce que quatre couches diffusées de contact (13 à 16) des électrodes du dispositif à effet Hall (1a) sont diffusées à la surface d'un caisson (19) de type de conduction opposé à celui du substrat (2) le contenant ; les quatre couches diffusées de contact (13 à 16) sont du même type de conduction que le caisson ; et une électrode de commande (18) sensiblement de même longueur est déposée parallèlement à et entre deux couches diffusées de contact (13, 15) parallèles et sensiblement de même longueur, sous forme d'une couche bonne conductrice sur la surface du caisson (19) dont elle est séparée par une mince couche isolante (20).

7. Montage selon une quelconque des revendications 3 à 6, caractérisé en ce que le montage régulateur (1d) est constitué par deux résistances (R3, R4) couplées en série, dont la borne commune forme la sortie (Q) du montage régulateur (1d) et dont l'autre borne forme l'entrée de valeur de consigne (A) ou de valeur instantanée (D) du montage régulateur (1d).

8. Montage selon revendication 7, caractérisé en ce qu'un suiveur de tension (21) est branché entre l'entrée de valeur instantanée (D) du montage régulateur (1d) et la résistance correspondante (R4).

9. Montage selon revendication 7, caractérisé en ce qu'un couplage en série des circuits « source-drain » de m transistors MOS ($T_1$ à $T_m$) est branché entre l'entrée de valeur de consigne (A) et sa résistance correspondante R3, et le couplage en série des circuits « source-drain » de n transistors MOS ($T_{m+1}$ à $T_{m+n}$) est branché entre l'entrée de valeur instantanée (D) et sa résistance correspondante (R4), l'entrée de valeur instantanée (D) étant dans ce dernier cas reliée à la « grille » du premier des n transistors MOS ($T_{m+1}$) et la « source » du premier des n transistors MOS ($T_{m+1}$) à une borne de la tension d'alimentation ($+ V_{DD}$ ; $- V_{SS}$).

10. Montage selon revendication 9, caractérisé en ce que les valeurs m et n sont choisies de façon à satisfaire à l'équation $m \cdot R4 = n \cdot R3$.

11. Montage selon une quelconque des revendications 3 à 6, caractérisé en ce que le montage régulateur (1d) est constitué par un amplificateur différentiel (23) dont la sortie forme la sortie (Q) du montage régulateur (1d) et dont les deux entrées forment chacune une entrée de valeur de consigne ou de valeur instantanée (A ou D) du montage régulateur (1d).

12. Montage selon une quelconque des revendications 3 à 6, caractérisé en ce que la tension appliquée à l'entrée de valeur instantanée (D) comprend en outre une chute de tension ($V_T$) produite par le courant d'alimentation (I) dans un élément sensible à la température.

13. Montage selon revendication 12, caractérisé en ce que l'élément sensible à la température est une résistance variant avec la température ($R_T$).

14. Montage selon revendication 12, caractérisé en ce que l'élément sensible à la température est le couplage en série de diodes polarisées dans le sens direct (D1, D2, ... Dn).

15. Montage selon une quelconque des revendications 12 à 14, caractérisé en ce que le montage régulateur (1d) est constitué uniquement par un fil de connexion.

# Fig. 1

# Fig. 2

## Fig. 3

## Fig. 4

## Fig. 5

## Fig. 6

## Fig. 7

## Fig. 8

Fig. 9

Fig. 10

Fig. 11